# EUROPEAN PATENT SPECIFICATION

(11) **EP 2 894 676 B1**
(45) Date of publication and mention of the grant of the patent: **19.05.2021**
(21) Application number: 15150388.5
(22) Date of filing: 07.01.2015
(51) Int. Cl.: H01L 31/05

(54) **Solar cell array having two different types of cells**
Solarzellenanordnung mit zwei verschiedenen Zelltypen
Réseau de cellules solaires ayant deux types différents de cellules

(30) Priority: 09.01.2014 US 201414151236
(43) Date of publication of application: 15.07.2015
(73) Proprietor: SolAero Technologies Corp., Albuquerque, NM 87123 (US)
(72) Inventor: Crist, Kevin, Sandia Park, New Mexico 87047 (US); Huang, Chetung George, Albuquerque, New Mexico 87113 (US); Steinfeldt, Jeffrey, Rio Rancho, New Mexico 87144 (US); Patel, Pravin, Albuquerque, New Mexico 87104 (US)
(74) Representative: Balder IP Law, S.L.

(56) References cited:
- WO-A1-2009/076740
- WO-A1-2010/135801
- WO-A1-2013/106896
- GB-A- 2 224 391
- US-A1- 2013 019 919

## Description

### FIELD OF THE INVENTION

The present disclosure relates to the field of solar cell arrays.

### BACKGROUND

Photovoltaic cells, also known as solar cells, are one of the most important new devices for producing electrical energy that has become commercially competitive with other energy sources over the past several years. Considerable effort has gone into increasing the solar conversion efficiency of solar cells. As a result, solar cells are currently being used in a number of commercial and consumer-oriented applications. While significant progress has been made in this area, the requirement for solar cells to meet the needs of more sophisticated applications has not kept pace with demand. Applications such as satellites used in data communications, for example, have dramatically increased the demand for solar cells with improved power and energy conversion characteristics.

Solar cells often are fabricated from semiconductor wafers in vertical, multifunction structures, and the wafers or cells are laid out in a planar array, with the individual solar cells connected together in columns in a series electrical current. The shape and structure of the columns forming the array, as well as the number of cells it contains, are determined in part by the desired output voltage and current.

Designing solar cell arrays presents a wide range of challenges. Moreover, competing engineering goals can be difficult to achieve in a single design. For example, it generally is desirable to provide a compact arrangement for the solar cells. This can be particularly important, for example, for satellite and other space related applications. On the other hand, a compact design can, in some cases, exacerbate other problems. For example, when differently-charged objects (e.g., negative and positive terminals of the solar cell array) are located close together, the buildup of electrostatic discharge (ESD) between the two objects can generate an electric spark. Such an ESD event can result in serious damage, for example, to a satellite's solar cells, and the satellite may suffer significant power loss. Thus, it is desirable to protect solar cell arrays, located for example on spacecraft, from sparking caused by electrostatic discharge.

US-2013/0019919-A1 discloses an arrangement based on solar cells having a substantially rectangular shape with cropped corners, and an upper surface featuring collector bars extending at least along one longer side and one shorter side of the solar cell.

### SUMMARY

The present disclosure describes solar cell arrays that include multiple cells connected to one another in series on a surface. The array includes first and second different types of solar cells. Incorporating two different types of cells can facilitate various layouts of the cells in the array, including compact arrangements. In some implementations, the use of two different types of cells can allow arrangements in which voltage terminals of opposite polarity to be disposed at a sufficiently large distance from one another so as to help reduce the occurrence of ESD.

In one aspect, for example, a solar cell device includes an array of solar cells disposed on a surface region having a periphery and an interior area. Each cell in the array has a top side and a bottom side, two long side edges opposite one another, and two short side edges opposite one another. The array includes cells of a first type and cells of a second different type. Each cell of the first type has metallization on its bottom side and one or more electrical contacts on its top side adjacent one of its short side edges.

Each cell of the second type has metallization on its bottom side and one or more electrical contacts on its top side adjacent one of its long side edges. The cells in the array are connected to one another in series. The solar cell device further includes a first terminal electrically connected directly to a first cell in the series connection, and a second terminal electrically connected directly to a last cell in the series connection. The first cell is disposed at the periphery, and the last cell is disposed at the interior area.

Some implementations include one or more of the following features. For example, the cells can be connected in series from the first cell to the last cell along a clockwise or counterclockwise winding path. In some case, the winding path has a spiral-type shape. In some instances, the first terminal is a lower voltage terminal of negative polarity, and the second terminal is a higher voltage terminal of positive polarity. Preferably, the second terminal is disposed at a location in the interior area that is sufficiently distant from the first terminal so as to reduce occurrence of electrostatic discharge.

According to another aspect, a solar cell panel can include multiple arrays of solar cells each of which can be configured as described above. Different ones of the arrays can have their cells arranged, for example, in a series connection along a clockwise or counterclockwise path so as to achieve cancellation of magnetic moments generated by currents in the arrays.

Other aspects, features and advantages will be apparent from the following detailed description, the accompanying drawings and the claims.

### BRIEF DESCRIPTION OF THE DRAWINGS

FIG. 1A is a top plan view of a first type of solar cell.
FIG. 1B is a top plan view of a second type of solar cell.
FIG. 2 shows additional details of the solar cell of FIG. 1B.
FIG. 3A illustrates an example of a solar cell panel.
FIG. 3B shows further details of a portion of FIG. 3A.
FIG. 4A illustrates an example of two interconnected solar cells.
FIG. 4B illustrates another example of two interconnected solar cells.
FIG. 5 illustrates an example of an interconnect member for connecting two adjacent solar cells electrically to one another.

### DETAILED DESCRIPTION

Broadly speaking, the present disclosure describes solar cell arrays that include multiple cells connected to one another in series on a surface. The array includes first and second different types of solar cells. Incorporating two different types of cells can facilitate various layouts of the cells in the array, including compact arrangements. The use of two different types of cells also can allow arrangements in which voltage terminals of opposite polarity, which are connected, respectively, to the first and last cells in the series, to be disposed at a sufficient distance from one another so as to help reduce the occurrence of ESD. For example, a first cell in the series connection can be disposed at the periphery of array, whereas a last cell in the series connection can be disposed, for example, at an interior area of the array.

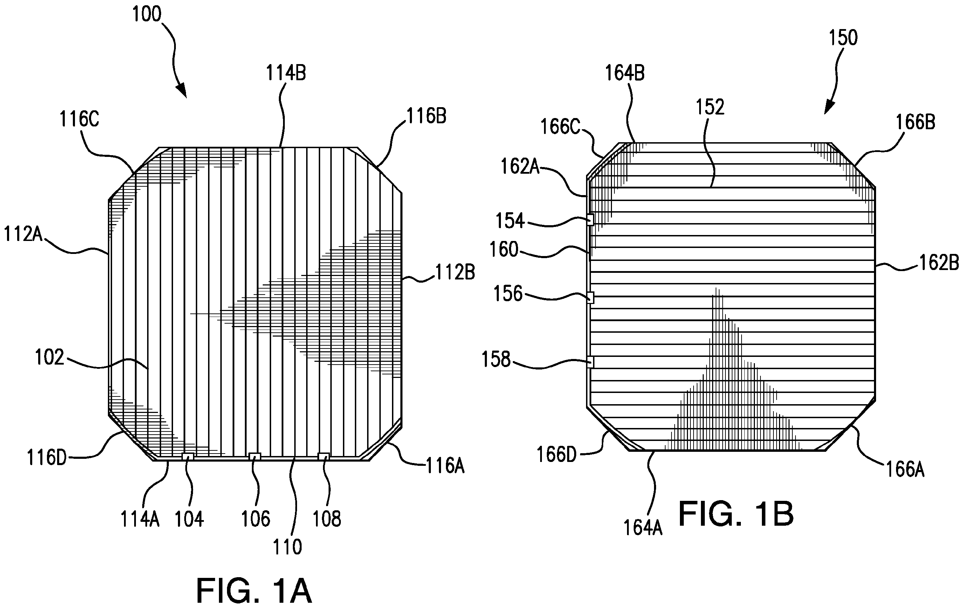

FIGS. 1A and 1B illustrate, respectively, examples of first and second types of solar cells in accordance with the invention. FIG. 1A is a top plan view of a semiconductor solar cell 100 of the first type. The solar cell 100, which can be scribed or cut out from a substantially circular semiconductor wafer at the end of a fabrication process, can have a substantially rectangular shape. In the illustrated example, the solar cell 100 has two parallel long side edges 112A, 112B opposite one another, and two parallel short side edges 114A, 114B opposite one another. The longer side edges 112A, 112B are substantially perpendicular to the shorter side edges 114A, 114B. In order to maximize the amount of each circular wafer that is used to form the solar cell, adjacent side edges of the solar cell may not form right-angles with one another; instead, the corners 116A, 116B, 116C, 116D of the solar cell 100 may appear as cut-off or rounded. The result is that the solar cell 100 may not be perfectly rectangular-shaped.

As further illustrated in FIG. 1A, one or more electrical contacts 104, 106, 108 are provided along one of the short side edges 114A at the top surface of the cell 100. Vertical conductors 102 extend in parallel over the top surface of the cell 100 and function to make electrical contact with the top layer of the cell and collect charge when the surface is illuminated. Thus, the conductors 102 extend substantially in parallel with the long side edges 112A, 112B. The top surface of the cell 100 also includes an electrically conducting bus 110, which extends along the periphery of the cell 100 at the short side edge 114A and at the corners 116A, 116D. The bus 110 functions to electrically connect each of the conductors 102, and also to connect to the electrical contacts 104, 106, 108 on the top surface of the cell 100. The bottom surface of the solar cell 100 can be covered substantially entirely with a metallic layer so as to serve as a lower, or bottom surface (i.e., backside), metallic contact for the cell 100.

In the illustrated example, the solar cell is an n-on-p device. Thus, the top surface (as shown in FIG. 1A) serves as the cathode, whereas the bottom or backside surface serves as the anode. The solar cell 100 can be, for example, a III-V multi-junction solar cell that includes a bottom cell, a middle cell and a top cell. Other implementations may use a different arrangement for the solar cell 100.

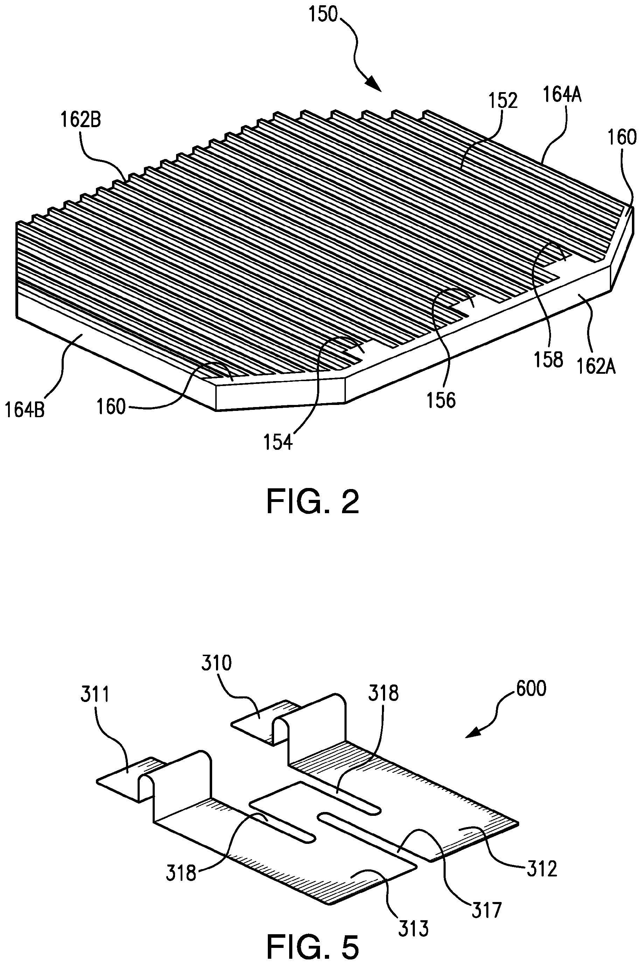

FIG. 1B is a top plan view of a semiconductor solar cell 150 of the second type, and FIG. 2 is a perspective view of the same solar cell. In many respects, the solar cell 150 of the second type can be similar to the solar cell 100 of the first type. Thus, the solar cell 150 can have two parallel long side edges 162A, 162B opposite one another, and two parallel short side edges 164A, 164B opposite one another. The longer side edges 162A, 162B are substantially perpendicular to the shorter side edges 164A, 164B. The overall shape and dimensions of the solar cell 150 can be substantially the same as the shape and dimensions of the solar cell 100. Here too, adjacent side edges of the solar cell 150 may not form right-angles with one another; instead, the corners 166A, 166B, 166C, 166D of the solar cell 150 may appear as cut-off or rounded. The result is that the solar cell 150 may not be perfectly rectangular-shaped.

As further illustrated in FIGS. 1B and 2, the second type of solar cell 150 also includes one or more electrical contacts 154, 156, 158 at the top surface of the cell 100. However, whereas the contacts 104, 106, 108 for the solar cell 100 of FIG. 1A are provided along one of the short side edges 114A, the contacts 154, 156, 158 for the solar cell 150 of FIG. 1B are provided along one of the long side edges 162A.

Horizontal conductors 152 extend in parallel over the top surface of the cell 150 and function to make electrical contact with the top layer of the cell and collect charge when the surface is illuminated. The conductors 152 extend substantially in parallel with the short side edges 164A, 164B. The top surface of the cell 150 also includes an electrically conducting bus 160, which extends along the periphery of the cell 100 at the long side edge 162A and at the corners 166C, 166D. The bus 110 functions to electrically connect each of the conductors 152, and also to connect to the electrical contacts 154, 156, 158 on the top surface of the cell 150. The bottom surface of the solar cell 150 can be covered substantially entirely with a metallic layer so as to serve as a lower, or bottom surface (i.e., backside), metallic contact for the cell 150.

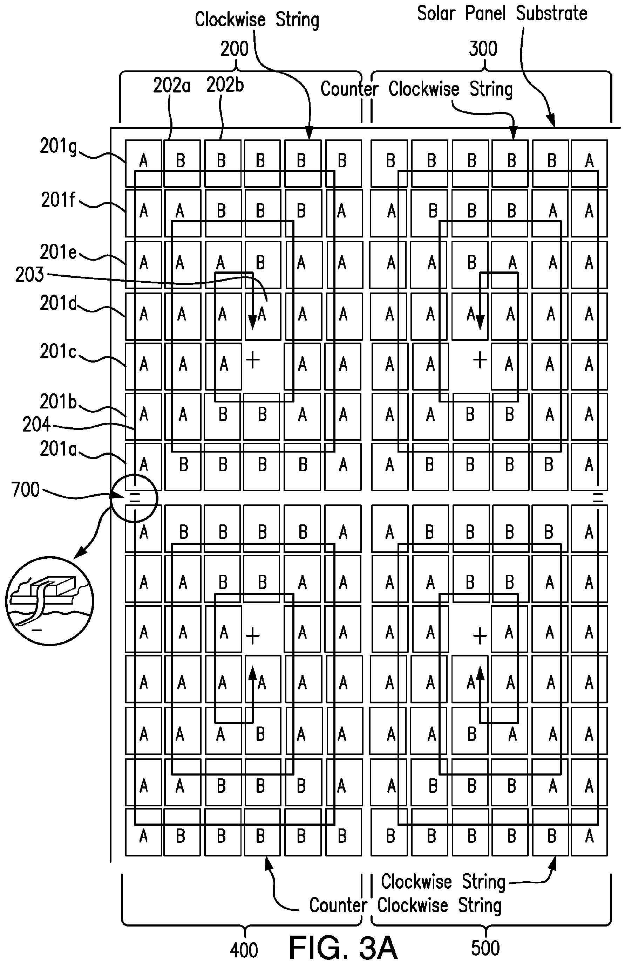

FIG. 3A illustrates multiple solar cell arrays 200, 300, 400, 500 each of which includes solar cells of two different types, A and B. In the illustrated examples, solar cells of type A correspond to the solar cell 100 of FIG. 1A, whereas solar cells of type B correspond to the solar cell 150 of FIG. 1B. The cells of each particular array (e.g., array 200) are arranged in a series connection and are supported, for example, by a lower substrate. The surface of the substrate on which the cells of a particular array are supported can include a periphery and an interior region.

Returning to the example of FIG. 3A, the series connection for the array 200 includes a first solar cell 201a whose bottom surface anode is connected to the top surface cathode contact(s) of the next adjacent cell 201b. In the illustrated example, the series connection of cells in the array 200 follows a clockwise spiral-type shape winding path 204 that starts with the first cell 201a at the periphery of the surface of the support substrate and ends with the last cell 203 disposed at the interior area of the surface of the support substrate. The support substrate is usually a composite material with an aluminum honeycomb core. Thus, the bottom surface anode of the cell 201b is connected to the top surface cathode contact(s) of the next adjacent 201c. The series connection continues in this fashion such that the bottom surface anode of each cell (other than the last cell 203) is connected to the top surface cathode contact(s) of the next adjacent cell.

In general, when connecting the bottom surface of one cell in the series to the electrical contacts on the top surface of the next cell, it is desirable for the electrical contacts on the next cell to be located at the side edge of that cell that is closest to a side edge of the previous cell. Thus, in the example of FIG. 2A, when a connection is made from one cell to a next cell in the same column, the next cell is of type A, which has electrical contacts on one of its short side edges (i.e., the short side edge that is adjacent to the previous cell). On the other hand, when a connection is made from one cell to a next cell in the same row, the next cell is of type B, which has electrical contacts on one of its longer side edges (i.e., the long side edge that is adjacent to the previous cell). Thus, in the example of FIG. 2A, when a connection is made from one cell to a next cell in the same row, the next cell is of type B, which has electrical contacts on one of its long side edges (i.e., the long side edge that is adjacent to the previous cell).

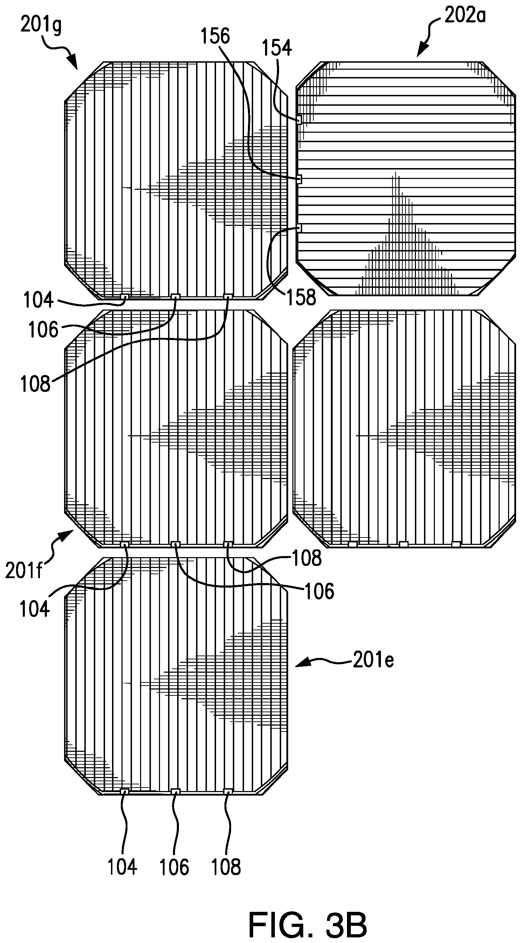

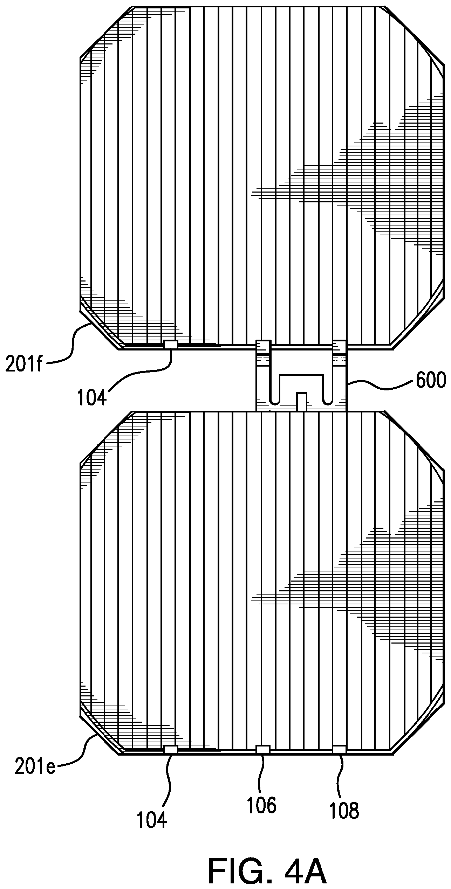

FIG. 3B, which shows a partial, enlarged version of the some of the cells 201e, 201f, 201g, 202a in the upper left-hand section of the array 200, illustrates the relative positioning of the cells and their top surface contacts. For example, the cell 201e and the next cell 201f are both of type A, and the top surface contacts 104, 106, 108 of the cell 201f are located at its lower side edge, which is adjacent the top side edge of the cell 201e. As illustrated in FIG. 4A, this allows the two cells 201e, 201f to be connected electrically by an interconnect 600 that connects the metalized bottom surface of the cell 201e to one or more of the top surface contacts of the cell 201f. The metallized bottom surface of the cell 201f can be connected by an interconnect 600 in a similar fashion to one or more of the top surface contacts of the next cell 201g, which also is of type A.

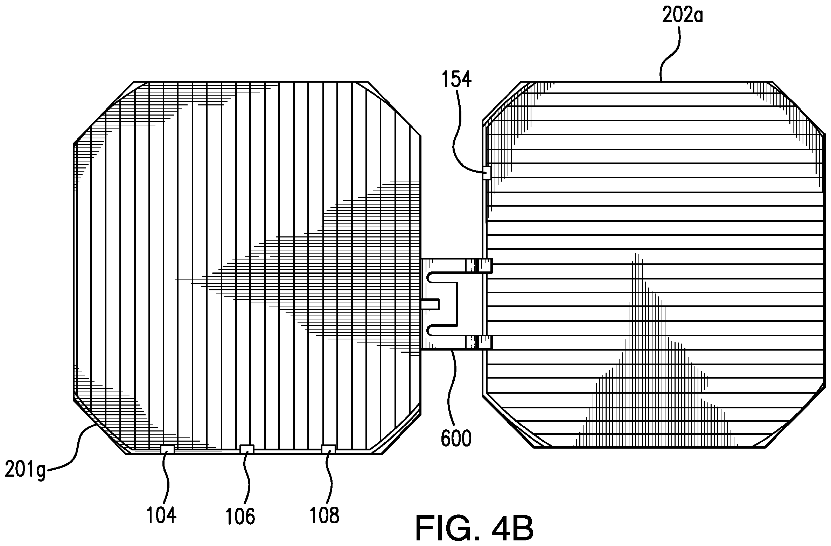

On the other hand, as further shown in FIG. 3B, the cell 201g in the upper left-hand corner of the array 200, is of type A, whereas the next cell 202a is of type B. The top surface contacts 154, 156, 158 of the cell 202a are located at its left-hand side edge, which is adjacent the right-hand side edge of the cell 201g. As further illustrated in FIG. 4B, this allows the two cells 201g, 202a to be connected electrically by an interconnect 600 that connects the metalized bottom surface of the cell 201g to one or more of the top surface contacts of the cell 202a. The metallized bottom surface of the cell 202a can be connected by an interconnect 600 in a similar manner to one or more of the top surface contacts of the next cell 202b, which also is of type B.

FIG. 5 illustrates further details of the interconnect 600 according to some implementations. The interconnect 600 can include, for example, first and second flat contact members 310, 311 that extend outward for contact, respectively, with two of the top surface contacts on one of the solar cells. Thus, the flat contact members 310, 311 should be spaced from one another at a distance that is the same as the distance between adjacent top surface contacts (e.g., contacts 104, 106 of the cell 201e; or contacts 156, 158 of the cell 202a). An advantage of providing two separate contact members and two top surface contacts is to achieve improved reliability in the event one of the electrical contacts is broken or otherwise shorts. The interconnect 600 of FIG. 5 is serpentine shaped, with middle portions 312, 313 for electrical contact with the metal layer on the bottom surface of one of the solar cells. The interconnect 600 can include one or more gaps 317, 318, where the planar surface changes direction, for stress relief. The details of the interconnect 600 may differ in other implementations.

As shown in FIG. 3A, each array (e.g., array 200) includes a first terminal electrically connected directly to the first cell 201a in the series connection, and a second terminal electrically connected directly to a last cell 203 in the series connection. In the illustrated example, the first terminal connected to the first cell 201a is a lower voltage terminal of negative (-) polarity, and the second terminal connected to the last cell 203 is a higher voltage terminal of positive (+) polarity. The second terminal can be disposed at an interior area of the array that is sufficiently distant from the first terminal so as to reduce occurrence of electrostatic discharge. In some cases, the second terminal may be disposed at or near the center of the array, although in other instances, this need not be the case. A feed-through hole for the positive (+) terminal can be provided through the support substrate on which the cells of the array are supported.

Although the series connection of the cells of the array 200 are arranged along a clockwise spiral-type path, in other arrays, the series connection of the cells can be arranged along a counterclockwise spiral-type path (see, e.g., arrays 300 and 400).

Further, although the cells of each array of FIG. 2A (e.g., array 200) are arranged in columns and rows, different configurations may be used for other implementations. For example, the array may include multiple rows, where the cells in a particular row are slightly offset or staggered from the cells of an adjacent row. Likewise, the array may include multiple columns, where the cells in a particular column are slightly offset or staggered from the cells of an adjacent column.

The number of solar cells in each array (e.g., array 200) can depend on the particular needs of the application for the solar cell array. In some implementations, there are at least twenty-seven cells, each of which provides about a two-volt increase. More generally, however, the array can include a greater or lesser number of cells.

Multiple solar cell arrays can be combined and connected electrically to form a solar cell panel. For example, as shown in FIG. 2A, four sub-arrays 200, 300, 400, 500 are provided to form a single panel. In this case, the negative (-) terminal of each of the sub-arrays 200, 300, 400, 500 can be connected to a common cathode bus 700. Each of the arrays 300, 400, 500 can be similar to the array 200 as described above. In some cases, the series connection of the cells in each particular array 200, 300, 400, 500 may follow a clockwise spiral-type shape winding path. In other cases, the series connection of the cells in each particular array 200, 300, 400, 500 may follow a counterclockwise spiral-type shape winding path. Preferably, however, some of the arrays in the panel have a clockwise spiral-type shape winding path, whereas other ones of the arrays have a counterclockwise spiral-type shape winding path. In particular, it can be desirable to orient the sub-arrays 200, 300, 400, 500 such that each sub-array whose cells are arranged in a series connection along a clockwise path is adjacent one or more other sub-arrays whose cells are arranged in a series connection along a counterclockwise path so as to achieve cancellation of magnetic moments generated by currents in the different sub-arrays. An example is illustrated in FIG. 2A, which shows sub-arrays 200 and 500 having clockwise spiral-type paths, and sub-arrays 300, 400 with counterclockwise spiral-type paths. Thus, in the illustrated example, each sub-array 200, 500 having a clockwise spiral-type path is adjacent only sub-arrays 300, 400 having a counterclockwise spiral-type path.

Although FIG. 3A shows a panel having four sub-arrays 200, 300, 400, 500, other implementations can include fewer or more arrays.

Other implementations are within the scope of the claims.

## Claims

1. A solar cell device comprising:
an array of solar cells (150, 160), wherein the cells are disposed on a surface region having a periphery and an interior area, each cell in the array having a top side and a bottom side, two long side edges (112A, 112B; 162A, 162B) opposite one another, and two short side edges (114A, 114B, 164A, 164B) opposite one another,
wherein the array includes:
cells of a first type (A) each of which has metallization on its bottom side and which has one or more electrical contacts (104, 106, 108) on its top side adjacent one of its short side edges (114A) and not adjacent the other one of its short side edges (114B) and not adjacent any of its long side edges (112A, 112B), and
cells (160) of a second different type (B) each of which has metallization on its bottom side and which has one or more electrical contacts (154, 156, 158) on its top side adjacent one of its long side edges (162A) and not adjacent the other one of its long side edges (162B) and not adjacent any of its short side edges (164A, 164B),
wherein the cells in the array are connected to one another in series;
the solar cell device further including:
a first terminal electrically connected directly to a first cell (201a) in the series connection, wherein the first cell is disposed at the periphery; and
a second terminal electrically connected directly to a last cell (203) in the series connection, wherein the last cell is disposed at the interior area.

2. The solar cell device of claim 1 wherein the cells are connected in series from the first cell (201a) to the last cell (203) along a clockwise or counterclockwise winding path.

3. The solar cell device of claim 2 wherein the winding path has a spiral-type shape.

4. The solar cell device of claim 2 wherein the first terminal is a lower voltage terminal of negative polarity, and the second terminal is a higher voltage terminal of positive polarity.

5. The solar cell device of claim 4 wherein the second terminal is disposed at a location in the interior area that is sufficiently distant from the first terminal so as to reduce occurrence of electrostatic discharge.

6. The solar cell device of claim 1 wherein, other than for the last cell in the series connection, the metallization on the bottom side of each particular cell is connected to one or more of the contacts (104, 106, 108; 154, 156, 158) on the top side of a next adjacent cell.

7. The solar cell device of claim 6 wherein the metallization on the bottom side of each cell is a first electrode of a first polarity, and wherein the one or more contacts on the top side of each cell are a second electrode of a second opposite polarity.

8. The solar cell device of claim 1 wherein the series connection of cells includes multiple transitions from a cell of the first type (A) to a next cell of the second type (B), and multiple transitions from a cell of the second type (B) to a next cell of the first type (A).

9. The solar cell device of claim 1 wherein the cells of the array are arranged in rows and columns.

10. The solar cell device of claim 1 wherein the surface region has a through-hole for connecting the second terminal to the last cell.

11. The solar cell device of any of the preceding claims, wherein said one or more electrical contacts (104, 106, 108; 154, 156, 158) are electrically connected to an electrically conducting bus (110, 160).

12. The solar cell device according to claim 11, wherein in cells of the first type (A), the electrically conducting bus extends along the periphery of the solar cell at a short side edge (114A) and corresponding corners (116A, 116D) of the solar cell, and wherein in the cells of the second type (B), the electrically conducting bus extends along the periphery of the solar cell at a long side edge (162A) and corresponding corners (166C, 166D) of the solar cell.

13. The solar cell device of any of claims 11 and 12 wherein the cells of the first type (A) further comprise conductors (102) that extend in parallel over the top surface of the respective cell (100) and are arranged to make electrical contact with a top layer of the respective cell and collect charge when the surface is illuminated, whereby the conductors (102) extend substantially in parallel with the long side edges (112A, 112B) of the respective cell, the electrically conducting bus (110) being electrically connected to each of the conductors (102).

14. The solar cell device of any of claims 11-13 wherein the cells of the second type (B) further comprise conductors (152) that extend in parallel over the top surface of the respective cell (150) and are arranged to make electrical contact with a top layer of the respective cell and collect charge when the surface is illuminated, whereby the conductors (152) extend substantially in parallel with the short side edges (164A, 164B) of the respective cell, the electrically conducting bus (160) being electrically connected to each of the conductors (152).

## Patentansprüche

1. Solarzellenvorrichtung, aufweisend:
eine Anordnung von Solarzellen (150, 160), wobei die Zellen auf einem Oberflächenbereich mit einer Peripherie und einem Innenbereich angeordnet sind, wobei jede Zelle in der Anordnung eine Oberseite und eine Unterseite, zwei lange Seitenkanten (112A, 112B; 162A, 162B), die einander gegenüberliegen, und zwei kurze Seitenkanten (114A, 114B, 164A, 164B), die einander gegenüberliegen, hat,
wobei die Anordnung aufweist:
Zellen eines ersten Typs (A), von denen jede eine Metallisierung auf ihrer Unterseite aufweist und die einen oder mehrere elektrische Kontakte (104, 106, 108) auf ihrer Oberseite benachbart zu einer ihrer kurzen Seitenkanten (114A) und nicht benachbart zu der anderen ihrer kurzen Seitenkanten (114B) und nicht benachbart zu einer ihrer langen Seitenkanten (112A, 112B) hat, und
Zellen (160) eines zweiten unterschiedlichen Typs (B), von denen jede eine Metallisierung auf ihrer Unterseite aufweist und die einen oder mehrere elektrische Kontakte (154, 156, 158) auf ihrer Oberseite benachbart zu einer ihrer langen Seitenkanten (162A) und nicht benachbart zu der anderen ihrer langen Seitenkanten (162B) und nicht benachbart zu irgendeiner ihrer kurzen Seitenkanten (164A, 164B) hat,
wobei die Zellen in der Anordnung miteinander in Reihe geschaltet sind;
wobei die Solarzellenvorrichtung ferner aufweist:
einen ersten Anschluss, der elektrisch direkt mit einer ersten Zelle (201a) in der Reihenschaltung verbunden ist, wobei die erste Zelle in der Peripherie angeordnet ist; und
einen zweiten Anschluss, der elektrisch direkt mit einer letzten Zelle (203) in der Reihenschaltung verbunden ist, wobei die letzte Zelle im Innenbereich angeordnet ist.

2. Solarzellenvorrichtung nach Anspruch 1, wobei die Zellen von der ersten Zelle (201a) bis zur letzten Zelle (203) im Uhrzeigersinn oder gegen den Uhrzeigersinn entlang eines Wicklungspfades in Reihe geschaltet sind.

3. Solarzellenvorrichtung nach Anspruch 2, wobei der Wicklungspfad eine spiralförmige Form hat.

4. Solarzellenvorrichtung nach Anspruch 2, wobei der erste Anschluss ein Anschluss mit niedrigerer Spannung und negativer Polarität ist und der zweite Anschluss ein Anschluss mit höherer Spannung und positiver Polarität ist.

5. Solarzellenvorrichtung nach Anspruch 4, wobei der zweite Anschluss an einer Stelle im Innenbereich angeordnet ist, die ausreichend von dem ersten Anschluss entfernt ist, um das Auftreten von elektrostatischer Entladung zu verringern.

6. Solarzellenvorrichtung nach Anspruch 1, wobei, außer bei der letzten Zelle in der Reihenschaltung, die Metallisierung auf der Unterseite jeder einzelnen Zelle mit einem oder mehreren der Kontakte (104, 106, 108; 154, 156, 158) auf der Oberseite einer nächsten benachbarten Zelle verbunden ist.

7. Solarzellenvorrichtung nach Anspruch 6, wobei die Metallisierung auf der Unterseite jeder Zelle eine erste Elektrode mit einer ersten Polarität ist, und wobei der eine oder die mehreren Kontakte auf der Oberseite jeder Zelle eine zweite Elektrode mit einer zweiten entgegengesetzten Polarität sind.

8. Solarzellenvorrichtung nach Anspruch 1, wobei die Reihenschaltung von Zellen mehrere Übergänge von einer Zelle des ersten Typs (A) zu einer nächsten Zelle des zweiten Typs (B) und mehrere Übergänge von einer Zelle des zweiten Typs (B) zu einer nächsten Zelle des ersten Typs (A) umfasst.

9. Solarzellenvorrichtung nach Anspruch 1, wobei die Zellen der Anordnung in Reihen und Spalten angeordnet sind.

10. Solarzellenvorrichtung nach Anspruch 1, wobei der Oberflächenbereich eine Durchgangsbohrung zum Verbinden des zweiten Anschlusses mit der letzten Zelle aufweist.

11. Solarzellenvorrichtung nach einem der vorhergehenden Ansprüche, wobei der eine oder die mehreren elektrischen Kontakte (104, 106, 108; 154, 156, 158) elektrisch mit einem elektrisch leitenden Bus (110, 160) verbunden sind.

12. Solarzellenvorrichtung nach Anspruch 11, wobei in Zellen des ersten Typs (A) der elektrisch leitende Bus sich entlang der Peripherie der Solarzelle an einer kurzen Seitenkante (114A) und entsprechenden Ecken (116A, 116D) der Solarzelle erstreckt, und wobei in den Zellen des zweiten Typs (B) der elektrisch leitende Bus sich entlang der Peripherie der Solarzelle an einer langen Seitenkante (162A) und entsprechenden Ecken (166C, 166D) der Solarzelle erstreckt.

13. Solarzellenvorrichtung nach einem der Ansprüche 11 und 12, wobei die Zellen des ersten Typs (A) ferner Leiter (102) aufweisen, die sich parallel über die obere Oberfläche der jeweiligen Zelle (100) erstrecken und so angeordnet sind, dass sie einen elektrischen Kontakt mit einer oberen Schicht der jeweiligen Zelle herstellen und Ladung sammeln, wenn die Oberfläche beleuchtet wird, wobei sich die Leiter (102) im Wesentlichen parallel zu den langen Seitenkanten (112A, 112B) der jeweiligen Zelle erstrecken, wobei der elektrisch leitende Bus (110) mit jedem der Leiter (102) elektrisch verbunden ist.

14. Solarzellenvorrichtung nach einem der Ansprüche 11 bis 13, wobei die Zellen des zweiten Typs (B) ferner Leiter (152) aufweisen, die sich parallel über die obere Oberfläche der jeweiligen Zelle (150) erstrecken und so angeordnet sind, dass sie einen elektrischen Kontakt mit einer oberen Schicht der jeweiligen Zelle herstellen und Ladung sammeln, wenn die Oberfläche beleuchtet wird, wobei sich die Leiter (152) im Wesentlichen parallel zu den kurzen Seitenkanten (164A, 164B) der jeweiligen Zelle erstrecken, wobei der elektrisch leitende Bus (160) mit jedem der Leiter (152) elektrisch verbunden ist.

## Revendications

1. Dispositif de cellule solaire comprenant :
un réseau de cellules solaires (150, 160), dans lequel les cellules sont disposées sur une région de surface ayant une périphérie et une zone intérieure, chaque cellule du réseau ayant un côté supérieur et un côté inférieur, deux bords latéraux longs (112A, 112B ; 162A, 162B) opposés l'un à l'autre, et deux bords latéraux courts (114A, 114B, 164A, 164B) opposés l'un à l'autre,
dans lequel le réseau comprend :
des cellules d'un premier type (A) qui présentent chacune une métallisation sur leur côté inférieur et qui possèdent un ou plusieurs contact(s) électrique(s) (104, 106, 108) sur leur côté supérieur adjacent à l'un de leurs bords latéraux courts (114A) et non adjacent à l'autre de leurs bords latéraux courts (114B) et non adjacent à un quelconque de leurs bords latéraux longs (112A, 112B), et
des cellules (160) d'un second type différent (B) qui présentent chacune une métallisation sur leur côté inférieur et qui possèdent un ou plusieurs contact(s) électrique(s) (154, 156, 158) sur leur côté supérieur adjacent à l'un de leurs bords latéraux longs (162A) et non adjacent à l'autre de leurs bords latéraux longs (162B) et non adjacent à un quelconque de leurs bords latéraux courts (164A, 164B),
dans lequel les cellules du réseau sont reliées les unes aux autres en série ;
le dispositif de cellule solaire comprenant en outre :
une première borne reliée de manière électrique directement à une première cellule (201a) au sein de la connexion en série, dans lequel la première cellule est disposée au niveau de la périphérie ; et
une seconde borne reliée de manière électrique directement à une dernière cellule (203) au sein de la connexion en série, dans lequel la dernière cellule est disposée au niveau de la zone intérieure.

2. Dispositif de cellule solaire selon la revendication 1, dans lequel les cellules sont reliées en série entre la première cellule (201a) et la dernière cellule (203) le long d'un trajet d'enroulement dans le sens des aiguilles d'une montre ou dans le sens inverse des aiguilles d'une montre.

3. Dispositif de cellule solaire selon la revendication 2, dans lequel le trajet d'enroulement possède une forme de spirale.

4. Dispositif de cellule solaire selon la revendication 2, dans lequel la première borne est une borne de tension moins élevée à polarité négative, et la seconde borne est une borne à tension plus élevée de polarité positive.

5. Dispositif de cellule solaire selon la revendication 4, dans lequel la seconde borne est disposée à un emplacement dans la zone intérieure qui est suffisamment distant de la première borne de façon à réduire l'occurrence d'une décharge électrostatique.

6. Dispositif de cellule solaire selon la revendication 1, dans lequel, en-dehors de la dernière cellule au sein de la connexion en série, la métallisation sur le côté inférieur de chaque cellule est reliée à un ou plusieurs des contacts (104, 106, 108 ; 154, 156, 158) sur le côté supérieur d'une cellule adjacente suivante.

7. Dispositif de cellule solaire selon la revendication 6, dans lequel la métallisation sur le côté inférieur de chaque cellule est une première électrode d'une première polarité, et dans lequel le ou les contact(s) sur le côté supérieur de chaque cellule est/sont une seconde électrode d'une seconde polarité opposée.

8. Dispositif de cellule solaire selon la revendication 1, dans lequel la connexion en série des cellules comprend plusieurs passages d'une cellule du premier type (A) à une cellule suivante du second type (B), et plusieurs passages d'une cellule du second type (B) à une cellule suivante du premier type (A).

9. Dispositif de cellule solaire selon la revendication 1, dans lequel les cellules du réseau sont disposées en rangées et en colonnes.

10. Dispositif de cellule solaire selon la revendication 1, dans lequel la région de surface possède un orifice traversant destiné à relier la seconde borne à la dernière cellule.

11. Dispositif de cellule solaire selon l'une quelconque des revendications précédentes, dans lequel ledit ou lesdits contact(s) électrique(s) (104, 106, 108 ; 154, 156, 158) est/sont électriquement relié(s) à un bus électriquement conducteur (110, 160).

12. Dispositif de cellule solaire selon la revendication 11, dans lequel, dans les cellules du premier type (A), le bus électriquement conducteur s'étend le long de la périphérie de la cellule solaire au niveau d'un bord latéral court (114A) et d'angles correspondants (116A, 116D) de la cellule solaire, et dans lequel, dans les cellules du second type (B), le bus électriquement conducteur s'étend le long de la périphérie de la cellule solaire au niveau d'un bord latéral long (162A) et d'angles correspondants (166C, 166D) de la cellule solaire.

13. Dispositif de cellule solaire selon l'une quelconque des revendications 11 et 12, dans lequel les cellules du premier type (A) comprennent en outre des conducteurs (102) qui s'étendent en parallèle sur la surface supérieure de la cellule respective (100) et sont disposés afin de créer un contact électrique avec une couche supérieure de la cellule respective, et de collecter une charge lorsque la surface est éclairée, moyennant quoi les conducteurs (102) s'étendent sensiblement en parallèle avec les bords latéraux longs (112A, 112B) de la cellule respective, le bus électriquement conducteur (110) étant relié électriquement à chacun des conducteurs (102).

14. Dispositif de cellule solaire selon l'une quelconque des revendications 11 à 13, dans lequel les cellules du second type (B) comprennent en outre des conducteurs (152) qui s'étendent en parallèle sur la surface supérieure de la cellule respective (150) et sont disposés afin de créer un contact électrique avec une couche supérieure de la cellule respective et de collecter une charge lorsque la surface est éclairée, moyennant quoi les conducteurs (152) s'étendent sensiblement en parallèle avec les bords latéraux courts (164A, 164B) de la cellule respective, le bus électriquement conducteur (160) étant relié électriquement à chacun des conducteurs (152).
